# EUROPÄISCHE PATENTANMELDUNG

(11) **EP 2 019 421 A2**
(43) Veröffentlichungstag der Anmeldung: **28.01.2009**
(21) Anmeldenummer: 08008715.8
(22) Anmeldetag: 09.05.2008
(51) Int. Cl.: H01L 21/60, H01L 23/485, H01L 23/48

(54) **Leistungshalbleiterbauelement mit Metallkontaktschicht sowie Herstellungsverfahren hierzu**

(30) Priorität: 26.07.2007 DE 102007022338
(71) Anmelder: SEMIKRON Elektronik GmbH & Co. KG, 90431 Nürnberg (DE)
(72) Erfinder: Göbl, Christian, 90441 Nürnberg (DE); Beckedahl, Peter, 90522 Oberasbach (DE); Heilbronner, Heinrich, Dr., 90547 Stein (DE)

(57) **Zusammenfassung**

Die Erfindung beschreibt ein Leistungshalbleiterbauelement (10) mit einem Grundkörper und mit mindestens einer Kontaktfläche (20,22,24), wobei auf dieser Kontaktfläche mindestens eine erste dünne metallische Schicht eines ersten Werkstoffs (30,32,34) angeordnet ist. Erfindungsgemäß ist eine weitere im Vergleich zur ersten dickeren metallische Schicht eines zweiten Werkstoffs (40,42,44) mittels einer Drucksinterverbindung dieses Werkstoffs hierauf angeordnet ist. Das zugehörige Verfahren weist die wesentlichen Schritte auf: Herstellung einer Mehrzahl von Leistungshalbleiterbauelementen im Waferverbund; Aufbringen mindestens einer ersten dünnen metallischen Schicht auf mindestens einer Kontaktfläche der jeweiligen Leistungshalbleiterbauelemente; Anordnung einer pastösen Schicht, aus dem zweiten Werkstoff und einem Lösungsmittel, auf mindestens einer der ersten metallischen Schichten je Leistungshalbleiterbauelement; Druckbeaufschlagung auf die pastöse Schicht; Vereinzeln der Halbleiterbauelemente.

## Beschreibung

Die Erfindung beschreibt ein Leistungshalbleiterbauelement mindestens einer Kontaktmetallisierung vorzugsweise mit einem monokristallinen Grundkörper und mindestens einem pn- Übergang. Derartige Leistungshalbleiterbauelemente sind beispielhaft Leistungsdioden, Leistungstransistoren oder Leistungsthyristoren, aber auch Solarzellen und Widerstandsbauelemente.

Die Kontaktmetallisierung dient der elektrisch leitenden Verbindung von Kontaktflächen des Halbleiterkörpers mit externen Verbindungselementen. Derartige Verbindungselemente können beispielhaft als Drahtbondverbindungen, löttechnisch verbundene Substrate oder druckkontaktierte Anschlusselemente ausgebildet sein.

Gemäß dem Stand der Technik ist eine Vielzahl unterschiedlicher Kontaktmetallisierungen üblich. Deren Ausgestaltung ist abhängig von ihrem jeweils vorgesehenen Kontaktpartner, beispielhaft einer Drahtbondverbindung. Daher sind speziell im Bereich der Leistungshalbleiterbauelemente mehrlagige Kontaktmetallisierungen bekannt, die aus einer Schichtfolge verschiedener Metalle aufgebaut sind. Innerhalb dieser Schichtfolgen sind die einzelnen Dicken der jeweiligen Schichten nicht gleich, liegen allerdings häufig im Bereich einige Zehntel Mikrometer bis einige Mikrometer.

Für die Verwendung in druckkontaktierten Anordnungen ist es auch bekannt zwischen dem Anschlusselement und dem Leistungshalbleiterbauelement eine Metallscheibe mit einer Dicke in der Größenordnung von Millimetern anzuordnen. Diese Metallscheibe dient der Reduktion von mechanischen Beanspruchungen des Leistungshalbleiterbauelements bzw. dessen Kontaktmetallisierung.

Der Erfindung liegt die Aufgabe zugrunde ein Leistungshalbleiterbauelement im Bereich der Kontaktmetallisierung weiterzubilden, damit die Kontakteigenschaften verbessert werden und ein Verfahren anzugeben wodurch das Leistungshalbleiterbauelement einer einfachen Herstellung zugänglich ist.

Diese Aufgabe wird erfindungsgemäß gelöst, durch ein Leistungshalbleiterbauelement mit den Merkmalen des Anspruchs 1 hergestellt mittels eines Verfahrens nach Anspruch 4. Bevorzugte Ausführungsformen sind in den Unteransprüchen beschrieben.

Ausgangspunkt der Erfindung ist ein Leistungshalbleiterbauelement vorzugsweise mit einem monokristallinen Grundkörper und mindestens einem pn- Übergang. Dieses Leistungshalbleiterbauelement weist im Bereich des Halbleiterkörpers mindestens eine Kontaktfläche auf, wobei auf dieser Kontaktfläche mindestens eine erste dünne metallische Schicht eines ersten Werkstoffs angeordnet ist. Auf mindestens einer dieser ersten metallischen Schichten ist eine, im Vergleich zu dieser, dickere metallische Schicht eines zweiten Werkstoffs angeordnet. Hierbei ist es bevorzugt, wenn der zweite metallische Werkstoff einen Anteil von mehr als 90 von 100 eines Edelmetalls aufweist. Besonders bevorzugt ist es hierbei, wenn dieses Edelmetall Silber ist.

Diese Anordnung wurde mittels einer Drucksinterverbindung ausgebildet. Wobei unter Drucksinterverbindung hier verstanden werden soll, dass eine Schicht eines Werkstoffs mittels des im Folgenden genannten Verfahrens angeordnet wird.

Das erfindungsgemäße Verfahren zur Herstellung eines derartigen Leistungshalbleiterbauelements weist folgende wesentliche Schritte auf:
- Herstellung einer Mehrzahl von Leistungshalbleiterbauelementen im Waferverbund.
- Aufbringen mindestens einer ersten dünnen metallischen Schicht auf mindestens einer Kontaktfläche der jeweiligen Leistungshalbleiterbauelemente
- Anordnung einer pastösen Schicht, aus dem zweiten Werkstoff und einem Lösungsmittel, auf mindestens einer der ersten metallischen Schichten je Leistungshalbleiterbauelement.
- Druckbeaufschlagung auf die pastöse Schicht. Hierbei ist es bevorzugt den überwiegenden Teil des Lösungsmittels vor der Druckbeaufschlagung aus der pastösen Schicht auszutreiben.
- Vereinzeln der Halbleiterbauelemente.

Es kann hierbei bevorzugt sein, wenn die pastöse Schicht mittels eines Schablonendruckverfahrens aufgebracht wird. Hierbei kann einerseits die notwendige Positioniergenauigkeit, bei der geforderten Schichtdicke, erreicht werden. Andererseits ist dieses Verfahren kostengünstig realisierbar.

Eine erste vorteilhafte Ausführung der Druckbeaufschlagung auf die pastöse Schicht kann durch die Anwendung einer Presse und zweier Pressstempel gegeben sein. Hierbei ist es zudem bevorzugt, wenn mindestens ein Pressstempel mit einem darauf angeordneten quasihydrostatischen Druck erzeugenden Silikonkissen ausgebildet ist.

Eine zweite vorteilhafte Ausführung der Druckbeaufschlagung auf die pastöse Schicht kann durch die Anwendung eines mit einer geeigneten Flüssigkeit oder Gas befüllten Drucktanks erfolgen. Hierbei ist es bevorzugt die Leistungshalbleiterbauelemente im Waferverbund und mittels einer Folie, vorzugsweise einer Teflonfolie, bedeckt in dem Drucktank anzuordnen und anschließend die Flüssigkeit in diesem von außen mit Druck zu beaufschlagen.

Besonders bevorzugte Weiterbildungen dieser Leistungshalbleiterbauelemente sowie des Herstellungsverfahrens sind in der jeweiligen Beschreibung der Ausführungsbeispiele genannt. Die erfinderische Lösung wird zudem an Hand der Ausführungsbeispiele der Fig. 1 bis 3 weiter erläutert.

Fig. 1 und 2 zeigen einzelne Schritte des erfindungsgemäßen Herstellungsverfahrens eines ersten erfindungsgemäßen Leistungshalbleiterbauelements.

Fig. 3 zeigt ein zweites erfindungsgemäßes Leistungshalbleiterbauelement.

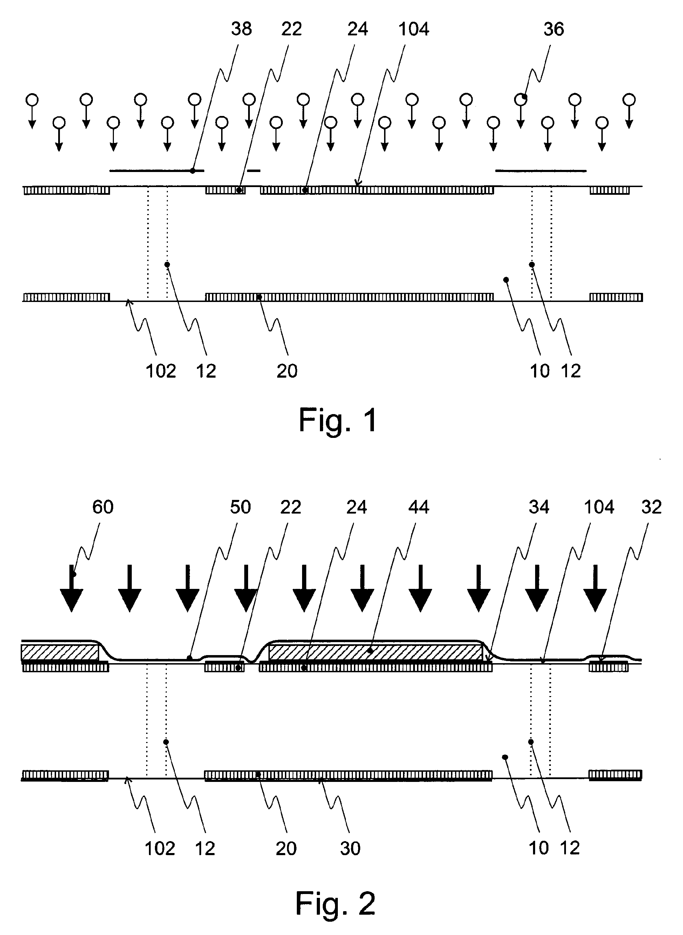

Fig. 1 und 2 zeigen einzelne Schritte des erfindungsgemäßen Herstellungsverfahrens eines ersten erfindungsgemäßen Leistungshalbleiterbauelements. In Fig. 1 ist der Halbleiterkörper mit den späteren Kanten (12) der Leistungshalbleiterbauelemente (10) und in diesem Halbleiterkörper in schematischer Weise einer Mehrzahl von Kontaktflächen (20, 22, 24) auf den beiden Hauptflächen (102, 104) dargestellt. Weiterhin ist die Herstellung der ersten dünnen Schicht des ersten metallischen Werkstoffs (36) dargestellt. Hierbei kommen gemäß dem Stand der Technik beispielhaft Bedampfungsverfahren mittels Schattenmasken (38) oder auch Sputterverfahren zum Einsatz. Mittels dieser langjährig bekannten Verfahren wird mindestens eine homogene Schicht mit einer Schichtdicke in der Größenordnung von Mikrometern abgeschieden. Es kann hierbei durchaus bevorzugt sein diese Schicht aus einer Mehrzahl dünner Einzelschichten aus jeweils unterschiedlichen Metallen mit jeweils verschiedener Schichtdicke abzuscheiden.

In einem nächsten nicht explizit dargestellten Schritt wird vorzugsweise mittels Schablonendrucktechnik eine pastöse Schicht (44, Fig. 2), wie sie aus Sinterverbindungen nach dem Stand der Technik bekannt ist, auf der ersten Schicht (34) angeordnet. Hierbei ist es nicht erfindungsrelevant, ob die Schichten (34, 44) direkt übereinander angeordnet sind, oder ob die pastöse zweite Schicht (44) die erste Schicht (34) geringfügig überdeckt oder auch nicht vollständig überdeckt.

Die pastöse Schicht (44, Fig. 2) selbst besteht aus einer Mischung eines metallischen Werkstoffs in Form von Metallflocken mit einer maximalen Ausdehnung in der Größenordnung von Mikrometern und einem Lösungsmittel. Als Material der Metallflocken eignet sich besonders Silber, aber auch andere Edelmetalle oder Mischungen mit einem Edelmetallanteil von mehr als 90 von 100.

Fig. 2 zeigt die Druckbeaufschlagung (60) auf die pastöse Schicht (44) zur Ausbildung einer, im Vergleich zur ersten, dickeren zweiten metallischen Schicht. Zusätzlich dargestellt und auch bevorzugt ist hier eine Folie (50), beispielhaft eine Teflonfolie, die vor der Druckbeaufschlagung (60) aufgebracht wurde. Hierbei ist es bevorzugt den gesamten Waferverbund abzudecken. Es ist allerdings in manchen Ausbildungen möglich selektiv nur die jeweilige pastöse Schicht mit der Folie zu bedecken.

Um eine ausreichend haftende Verbindung zwischen der pastösen Schicht (44) und der ersten metallischen Schicht (34) auszubilden ist es bevorzugt, wenn der maximale eingeleitete Enddruck bei der Druckbeaufschlagung (60) mindestens 15MPa entspricht.

Weiterhin kann es vorteilhaft sein zusätzlich zur Druckbeaufschlagung (60) das Leistungshalbleiterbauelement (10) bzw. den Halbleiterkörper auf mehr als 350K zu erwärmen. Diese ist vorteilhaft zur Entfernung des Lösungsmittels aus der pastösen Schicht (44), da die fertige metallische Schicht kein Lösungsmittel mehr enthalten soll.

Diese zweite metallische Schicht weist nach der Druckbeaufschlagung (60) eine bevorzugte Dicke zwischen 10µm und 80µm auf, wobei auch Schichten zwischen 1µm und 250µm herstellbar sind und je nach Anwendung auch sinnvoll sind.

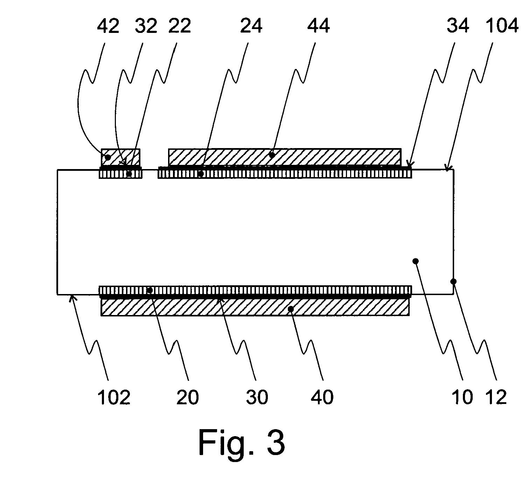

Fig. 3 zeigt ein zweites erfindungsgemäßes Leistungshalbleiterbauelement (10), hier einen Leistungsthyristor. Dessen Halbleiterkörper weist an seiner ersten Hauptfläche (102) eine erst Kontaktfläche (20), hier die Kathode, und an seiner zweiten Hauptfläche (104) zwei weitere Kontaktflächen (22, 24), einen Steuereingang, das Gate (22), und eine Anode (24) auf. In dieser Ausgestaltung sind all diese Kontaktflächen erfindungsgemäß weitergebildet.

Jede Kontaktfläche (20, 22 ,24) weist eine erste Schicht aus einem ersten metallischen Werkstoff (30, 32, 34), hier Teilschichten verschiedener Werkstoffe mit einer letzten Teilschicht aus Silber und einer gesamten Schichtdicke von ca. 5µm, auf. Dieser erste Werkstoff (30, 32, 34) wird von einem mittels Drucksinterverfahren angeordneten zweite metallischen Werkstoff (40, 42, 44), hier ebenfalls Silber mit einer Schichtdicke von 50µm, überdeckt.

Ein derartig ausgebildetes Leistungshalbleiterbauelement (10) weist den Vorteil einer einfachen Herstellung (vgl. Fig. 1 und 2) auf. Andererseits kann ein derartiges Leistungshalbleiterbauelement (10) in einem druckkontaktierten Aufbau eingesetzt werden, ohne dass zwischen dem nicht dargestellten Anschlusselement und dem Leistungshalbleiterbauelement (10) selbst eine weitere metallische Scheibe mit einer Dicke im Bereich von 0,2mm bis 4mm angeordnet ist. Die Aufgabe diese Scheibe wird durch die dicke zweite metallische Schicht (40, 42, 44) übernommen.

Die Voreile des erfindungsgemäßen Leistungshalbleiterbauelements (10) sind auch in der Kombination mit weiteren Verbindungstechniken vorteilhaft. Speziell für die Herstellung einer Sinterverbindung des Leistungshalbleiterbauelements (10) mit einem Substrat ist es notwendig, dass das Leistungshalbleiterbauelement (10) eine Edelmetalloberfläche zur Verbindung aufweist. Zudem ist es vorteilhaft, wenn diese Edelmetalloberfläche eine Schichtdicke aufweist, die über 10µm liegt. Derartige Schichten lassen sich mit dem beschriebenen Verfahren wesentlich einfacher und kostengünstiger herstellen im Vergleich zur Herstellung mittels Standardverfahren, beispielhaft mittels eines Bedampfungs- oder Sputterverfahren.

## Patentansprüche

1. Leistungshalbleiterbauelement (10) mit einem Grundkörper und mit mindestens einer Kontaktfläche (20, 22, 24), wobei auf dieser Kontaktfläche (20, 22, 24) mindestens eine erste dünne metallische Schicht eines ersten Werkstoffs (30, 32, 34) angeordnet ist und eine weitere im Vergleich zur ersten dickeren metallische Schicht eines zweiten Werkstoffs (40, 42, 44) mittels einer Drucksinterverbindung dieses Werkstoffs angeordnet ist.

2. Leistungshalbleiterbauelement nach Anspruch 1,
wobei der zweite metallische Werkstoffs (40, 42, 44) einen Anteil von mehr als 90 von 100 eines Edelmetalls aufweist.

3. Leistungshalbleiterbauelement nach Anspruch 2,
wobei das Edelmetall Silber ist.

4. Verfahren zur Herstellung eines Leistungshalbleiterbauelements (10) nach Anspruch 1 mit den wesentlichen Schritten:
• Herstellung einer Mehrzahl von Leistungshalbleiterbauelementen (10) im Waferverbund;
• Aufbringen mindestens einer ersten dünnen metallischen Schicht (30, 32, 34) auf mindestens einer Kontaktfläche (20, 22, 24) der jeweiligen Leistungshalbleiterbauelemente (10);
• Anordnung einer pastösen Schicht (40, 42, 44), aus dem zweiten Werkstoff und einem Lösungsmittel, auf mindestens einer der ersten metallischen Schichten je Leistungshalbleiterbauelement (10);
• Druckbeaufschlagung (60) auf die pastöse Schicht (40, 42, 44);
• Vereinzeln der Halbleiterbauelemente (10).

5. Verfahren nach Anspruch 4,
wobei die pastöse Schicht (40, 42, 44) mittels eines Schablonendruckverfahrens aufgebracht wird.

6. Verfahren nach Anspruch 4,
wobei der Druck (60) mittels einer Presse und zweier Pressstempel, wobei mindestens ein Pressstempel mit einem darauf angeordneten quasihydrostatischen Druck erzeugenden Silikonkissen ausgebildet ist, aufgebracht wird.

7. Verfahren nach Anspruch 4,
wobei der Druck (60) in einem von außen mit Druck beaufschlagten und mit Flüssigkeit oder Gas gefüllten Drucktank gebildet wird und das Leistungshalbleiterbauelement (10) im Waferverbund vollständig in diesem Drucktank angeordnet ist.

8. Verfahren nach Anspruch 4,
wobei der maximale Enddruck bei der Druckbeaufschlagung (60) mindestens 15MPa entspricht.

9. Verfahren nach Anspruch 4,
wobei während der Druckbeaufschlagung (60) das Leistungshalbleiterbauelement (10) auf mehr als 350K erwärmt ist.

10. Verfahren nach Anspruch 4,
wobei vor der Druckbeaufschlagung (10) die Oberfläche der pastösen Schicht (40, 42, 44) oder der gesamte Waferverbund mit einer Folie (50) bedeckt wird.
